# FASCICULE DE BREVET EUROPEEN

(11) **EP 2 380 864 B1**
(45) Date de publication et mention de la délivrance du brevet: **06.11.2013**
(21) Numéro de dépôt: 11159635.9
(22) Date de dépôt: 24.03.2011
(51) Int. Cl.: B44C 1/26, C04B 41/90, C04B 41/00, C04B 41/52, G04B 19/18, G04B 19/28

(54) **Procédé de fabrication d'un élément céramique incrusté d'au moins un décor métallique**
Verfahren zur Herstellung eines Keramikelements mit mindestens einem Metalldekoreinsatz
Process for producing a ceramic element inlaid with at least one metal decoration

(30) Priorité: 23.04.2010 EP 10160893
(43) Date de publication de la demande: 26.10.2011
(73) Titulaire: Omega SA, 2500 Biel/ Bienne 4 (CH)
(72) Inventeur: Grossenbacher, Pascal, 2000 Neuchâtel (CH); Caillaud, Michel, 25130 Villers-le-Lac (FR); Netuschill, Alexandre, 2400 Le Prévoux (CH)
(74) Mandataire: Couillard, Yann Luc Raymond

(56) Documents cités:
- EP-A1- 0 106 806
- EP-A1- 0 230 853
- EP-A1- 1 548 524
- FR-A1- 2 491 956
- JP-A- 5 214 550

## Description

### Domaine de l'invention

L'invention se rapporte à un élément céramique incrusté d'au moins un décor métallique et plus précisément un tel élément destiné à être monté notamment dans une pièce d'horlogerie.

### Arrière-plan de l'invention

Il est connu de former des lunettes de montre au moins partiellement en saphir synthétique pour montrer, par transparence, un dépôt effectué dans un creux sous la lunette formant par exemple une graduation ou une dénomination commerciale. Cette configuration à l'avantage de protéger le dépôt de toute dégradation mécanique par recouvrement total de la partie en saphir. Cependant, cette configuration peut rendre difficile la lecture du décor par la transmission altérée de la coloration du dépôt mais également par le manque de différence de la teinte du saphir par rapport à celle du dépôt.

Le document EP 1 548 524 propose de fabriquer une lunette en céramique dont les décors sont creusés avant frittage afin d'offrir des flancs essentiellement perpendiculaires à la surface visible. Chaque décor peut ensuite être au moins partiellement rempli d'un motif.

### Résumé de l'invention

Le but de la présente invention est de pallier tout ou partie les inconvénients cités précédemment en gardant l'avantage de la résistance mécanique en apportant celui d'une qualité visuelle améliorée.

A cet effet, l'invention se rapporte à un procédé de fabrication d'un élément céramique incrusté comportant les étapes suivantes :
a) former un corps en céramique ;
b) graver par laser au moins un évidement comportant une profondeur minimale de 100 µm dans une face du corps en céramique, chaque au moins un évidement formant l'empreinte d'un décor ;
c) déposer une première couche de sensiblement 50 nm sur l'ensemble de la face comportant ledit au moins un évidement ;
d) déposer une deuxième couche électriquement conductrice de sensiblement 50 nm sur l'ensemble de la face comportant ledit au moins un évidement en recouvrement de la première couche ;
e) déposer galvaniquement un matériau métallique à partir de la deuxième couche conductrice afin de remplir complètement ledit au moins un évidement ;
f) retirer tous les dépôts de la surface du corps en céramique afin de n'en laisser que dans le creux dudit au moins un évidement.

On réalise immédiatement que la variété des teintes du décor et/ou de la céramique n'est plus limitée par la transparence de cette dernière tout en gardant une bonne résistance à l'usure. A titre d'exemple, il est ainsi possible d'obtenir un rendu visuel complexe en donnant un aspect brillant à la céramique et un aspect satiné à chaque décor. De manière avantageuse, on comprend également que l'élément céramique peut notamment former indifféremment tout ou partie d'une pièce d'horlogerie, c'est-à-dire d'un boîtier, d'un bracelet, d'une lunette, d'un cadran, d'une glace, d'un poussoir et/ou d'une couronne d'une montre. L'invention peut également s'appliquer à tout ou partie d'un article de bijouterie ou de joaillerie ou encore s'appliquer aux arts de la table.

Conformément à d'autres caractéristiques avantageuses de l'invention :
- l'étape a) est réalisée par frittage ;
- le corps en céramique est formé à base de zircone ;
- chaque au moins un évidement comporte une surface interne sans arête afin de faciliter la mise en oeuvre de l'étape e) ;
- l'étape c) est réalisée par autocatalyse chimique ou par dépôt physique en phase vapeur ;
- la première couche électriquement conductrice est du type Cr, Cr₂N, TiN, TiW, Ni, NiP, Cu, Ti ou Zr ;
- l'étape d) est réalisée par dépôt physique en phase vapeur ;
- la deuxième couche électriquement conductrice comporte de l'or et/ou du cuivre et/ou de l'argent et/ou de l'indium et/ou du platine et/ou du palladium et/ou du nickel afin d'optimiser son adhérence, sa bonne conductivité électrique et une teinte proche du dépôt galvanique ;
- le matériau métallique déposé lors de l'étape e) comporte de l'or et/ou du cuivre et/ou de l'argent et/ou de l'indium et/ou du platine et/ou du palladium et/ou du nickel ;
- le procédé comporte une étape finale g) destinée à déposer une couche sensiblement transparente afin de protéger les décors du vieillissement comme par exemple une couche de nitrure de silicium.

### Description sommaire des dessins

D'autres particularités et avantages ressortiront clairement de la description qui en est faite ci-après, à titre indicatif et nullement limitatif, en référence aux dessins annexés, dans lesquels :
- la figure 1 est une représentation d'une pièce d'horlogerie selon l'invention ;
- la figure 2 est une vue en coupe d'un élément céramique incrusté selon l'invention ;
- les figures 3 à 8 sont des étapes successives du procédé de fabrication selon l'invention ;
- la figure 9 est un schéma fonctionnel du procédé selon l'invention.

### Description détaillée des modes de réalisation préférés

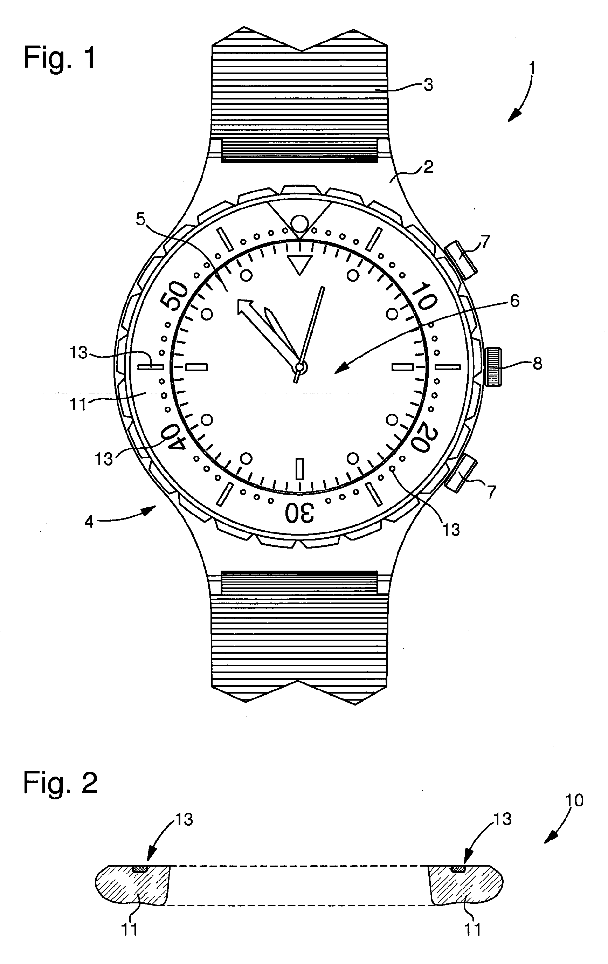

Dans l'exemple illustré à la figure 1, on peut voir une pièce d'horlogerie généralement annotée 1 comportant au moins un élément céramique incrusté. Chaque élément céramique incrusté est destiné à former une pièce très résistante à l'usure comportant au moins un décor métallique dont la qualité visuelle est améliorée notamment en terme de contraste.

L'élément céramique incrusté selon l'invention peut notamment former indifféremment tout ou partie de l'habillage de la pièce d'horlogerie 1. Ainsi, il pourrait former tout ou partie d'un boîtier 2, d'un bracelet 3, d'une lunette 4, d'un cadran 5, d'une glace 6, d'un poussoir 7 et/ou d'une couronne 8. Dans l'exemple illustré ci-après, l'explication de l'invention sera donnée à partir d'un anneau 10 en céramique comportant des décors 13 incrustés formant les graduations d'une lunette 4.

Comme illustré aux figures 1, 2 et 8, l'élément céramique incrusté 10 comporte un corps 11 en céramique comportant au moins un évidement 12 formant l'empreinte d'un décor 13. A la figure 1, on peut voir que chaque décor 13, avantageusement selon l'invention, peut être de forme quelconque, comme, par exemple, une figure géométrique ou un caractère alphanumérique. Selon l'invention, chaque évidement 12 est entièrement rempli par deux couches 14, 15 électriquement conductrices d'une épaisseur chacune sensiblement égale à 50 nm et par un dépôt 16 galvanique formé par un matériau métallique. Cette configuration permet de protéger chaque décor 13 dans le corps 11 en céramique lequel est très résistant à l'usure.

Afin d'améliorer l'accrochage du décor 13 dans le corps 11, l'évidement 12 comporte une profondeur P minimale de 100 µm. De plus, pour les mêmes raisons, préférentiellement, chaque évidement 12 comporte une surface continue au moins partiellement rayonnée R, c'est-à-dire que leur surface interne ne comporte pas d'arêtes. En effet, les dépôts galvaniques peuvent subir des défauts de remplissage à cause d'effets de pointes au niveau de zones comportant des arêtes.

Le corps 11 en céramique peut être obtenu à partir d'une grande variété de matériaux. Cependant, une céramique à base de zircone est préférentiellement utilisée pour ses propriétés mécaniques, sa capacité de polissage et, dans une moindre mesure, pour sa capacité à offrir une large palette de teintes. Il est bien entendu évident que d'autres céramiques sont envisageables, comme, par exemple, à base de carbure de titane.

La première couche 14 est destinée à améliorer la force d'accrochage du futur décor 13 sur le corps en céramique 11. En effet, même si la microrugosité du fond de l'évidement 12 contribue à l'adhérence, de manière préférée, une première couche 14 est déposée. Préférentiellement, la première couche 14 comporte une épaisseur de sensiblement 50 nm et est située entre la deuxième couche électriquement conductrice 15 et le corps 11 en céramique. Suivant le mode de dépôt de la première couche 14, il peut être envisagé plusieurs types de matériaux, comme, par exemple, du type Cr, Cr₂N, TiN, TiW, Ni, NiP, Cu, Ti ou Zr.

De manière similaire, pour la deuxième couche électriquement conductrice 15 et le dépôt galvanique 16, il est également possible d'envisager une large variété de matériaux. Préférentiellement, la deuxième couche électriquement conductrice 15 est choisie afin de se rapprocher le plus possible de la teinte du dépôt galvanique 16. La deuxième couche 15 est également choisie pour sa capacité d'adhérence et sa bonne conductivité électrique nécessaire à l'électrodéposition.

De plus, selon l'invention, le rendu visuel de chaque décor 13 est principalement obtenu par la teinte du dépôt galvanique 16. Par conséquent, le matériau utilisé pour le dépôt galvanique 16 sera préférentiellement guidé par sa teinte ou plus globalement son rendu esthétique. A ce titre, le dépôt galvanique métallique 16 et, incidemment, la deuxième couche 15 comportent de l'or et/ou du cuivre et/ou de l'argent et/ou de l'indium et/ou du platine et/ou du palladium et/ou du nickel.

A titre d'exemple, il est ainsi possible d'obtenir un rendu visuel complexe en donnant un aspect brillant au corps céramique 11 et un aspect satiné aux décors 13. Il est également envisageable, afin d'uniformiser les teintes, de former des décors 13 du même matériau que celui qui entoure le corps 11 en céramique. On pourrait ainsi, dans un exemple de réalisation de la figure 1, avoir des décors 13 de lunette 4 du même matériau que le boîtier 2, le bracelet 3, le reste de la lunette 4, le cadran 5, les poussoirs 7 et/ou la couronne 8.

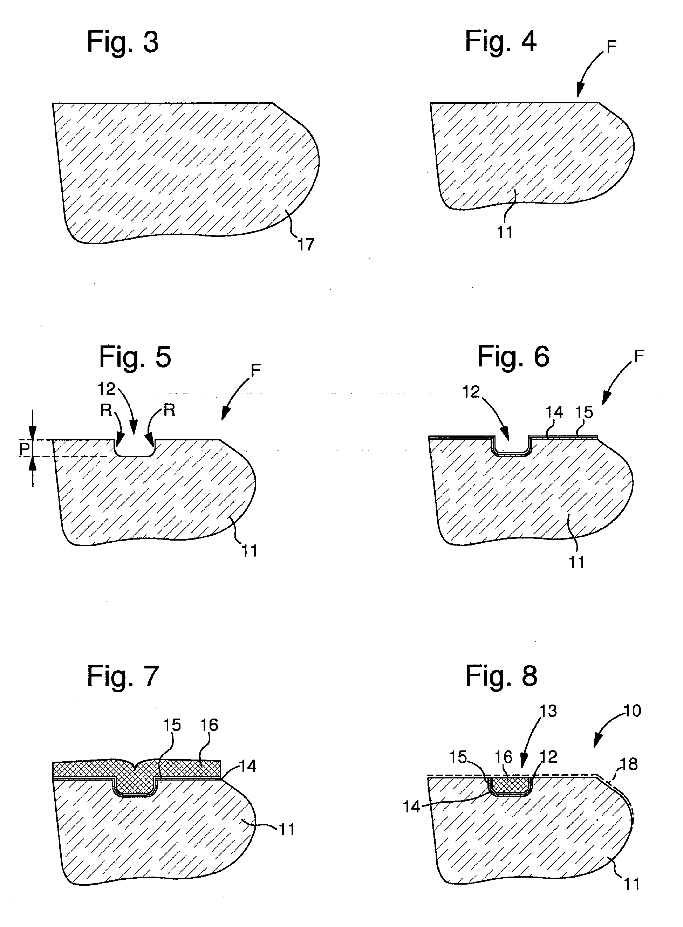

Enfin, comme illustré à la figure 8, l'élément céramique incrusté 10 peut, selon l'invention, également prévoir une couche optionnelle 18 sensiblement transparente afin de protéger les décors 13 du vieillissement. Une telle couche 18 peut, par exemple, comporter du nitrure de silicium permettant notamment de lutter contre le ternissement des couches 15 et/ou 16 surtout lorsque celles-ci sont formées principalement à base d'argent.

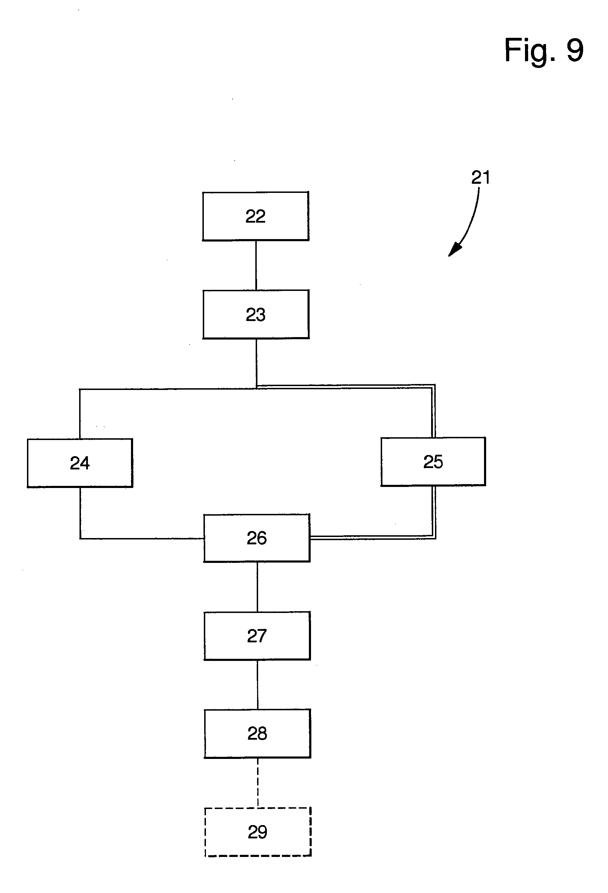

Le procédé de fabrication 21 d'un élément céramique incrusté 10 va maintenant être expliqué à partir des figures 3 à 9. Dans une première étape 22 illustrée à la figure 9, le procédé 21 consiste à former le corps 11 en céramique, par exemple, en zircone. Comme le montre partiellement le passage de la figure 3 à la figure 4, la céramique finale 11 de l'étape 22 est obtenue préférentiellement par frittage, c'est-à-dire à partir d'un corps vert 17 préformé à l'aide d'un processus d'injection. A la fin de l'étape 22, le corps 11 visible à la figure 4 comporte ses dimensions finales.

Comme illustré à la figure 9, le procédé 21 comporte une deuxième étape 23 destinée à graver au moins un évidement 12 qui peut être borgne dans une face F du corps 11 en céramique, les évidements 12 formant l'empreinte des futurs décors 13 comme visible à la figure 5. Chaque évidement 12 comporte une profondeur P minimale de 100 µm. De plus, de manière préférée, chaque évidement 12 comporte une surface continue au moins partiellement rayonnée R afin de faciliter la mise en oeuvre de l'étape 27 d'électrodéposition expliquée ci-dessous. L'étape 23 est obtenue par un rayonnement destructif au moyen d'un laser permettant d'obtenir une bonne précision des gravures.

Comme illustré à la figure 9, le procédé 21 se poursuit selon une troisième étape destinée à déposer une première couche 14 électriquement conductrice d'une épaisseur sensiblement égale à 50 nm sur l'ensemble de la face F, c'est-à-dire y compris dans chacun des évidements 12 comme visible à la figure 6. Selon l'invention, cette étape peut être obtenue selon deux modes de réalisation préférés.

Dans un premier mode de réalisation, visible en trait simple à la figure 9, la troisième étape 24 du procédé 21 consiste à revêtir la face F par voie humide, comme par exemple une autocatalyse chimique (également connue sous le terme anglais « electroless »). Il est ainsi possible de déposer, par exemple, une couche de nickel-phosphore chimique qui adhère parfaitement au corps 11 en céramique et qui forme une très bonne couche d'adhésion pour l'étape 26 ultérieure.

Dans un deuxième mode de réalisation, visible en trait double à la figure 9, la troisième étape 25 du procédé 21 consiste à revêtir la face F par voie sèche, comme par exemple un dépôt physique en phase vapeur. Il est ainsi possible de déposer, par exemple, une couche du type Cr, Cr₂N, TiN, TiW, Ni, Cu, Ti ou Zr qui adhère parfaitement au corps 11 en céramique et qui forme une très bonne couche d'adhésion pour l'étape 26 ultérieure.

Quel que soit le mode de réalisation choisi, le procédé 21 se poursuit avec une quatrième étape 26 destinée à déposer une deuxième couche 15 électriquement conductrice d'une épaisseur sensiblement égale à 50 nm sur l'ensemble de la face F c'est-à-dire y compris dans les évidements 12 et en recouvrement de la première couche 14 afin d'offrir une surface optimisée pour l'étape 27 d'électrodéposition. Comme expliqué ci-dessus, l'optimisation s'entend quant à l'adhérence, à la bonne conductivité électrique et à la teinte proche du dépôt galvanique 16.

Par conséquent, une telle couche 15 peut, par exemple, être de l'or et/ou du cuivre et/ou de l'argent et/ou de l'indium et/ou du platine et/ou du palladium et/ou du nickel. De plus, l'étape 26 est de manière préférée réalisée par voie sèche, comme, par exemple, par dépôt physique en phase vapeur. Dans un tel cas, on comprend que, dans le cas du premier mode de réalisation, l'étape 25 et l'étape 26 peuvent être réalisées dans une même enceinte.

Le procédé 21 se poursuit par une cinquième étape 27 destinée à déposer galvaniquement un matériau métallique 16 à partir de la couche conductrice 15 afin de remplir complètement chaque évidement 12 comme visible à la figure 7. Préférentiellement, un renouvellement de l'électrolyte dans les évidements 12 est forcé par une agitation, c'est-à-dire la mise en place d'un déplacement forcé des fluides du bain galvanique, afin d'éviter des problèmes de remplissage des évidements 12.

Comme expliqué ci-dessus, suivant la teinte ou plus globalement le rendu visuel souhaité, le matériau métallique déposé lors de l'étape 27 comporte de l'or et/ou du cuivre et/ou de l'argent et/ou de l'indium et/ou du platine et/ou du palladium et/ou du nickel.

Enfin, dans une sixième étape 28, le procédé 21 se termine en retirant les dépôts 14, 15 et 16 de la surface F du corps 11 en céramique afin de n'en laisser qu'au niveau de chaque évidement 12 comme visible aux figures 2 et 8. L'élément céramique incrusté 10 est ainsi terminé et n'a, éventuellement, plus qu'à être monté sur une pièce finale. Cette étape 28 peut être obtenue par une méthode de surfaçage habituelle comme un meulage ou un rodage pour enlever le surplus de matière suivit d'un polissage.

Le procédé 21 selon l'invention, peut également prévoir une dernière étape optionnelle 29 destinée à déposer une couche 18 sensiblement transparente afin de protéger les décors 13 du vieillissement. Une telle couche peut, par exemple, comporter du nitrure de silicium permettant notamment de lutter contre le ternissement des couches 15 et/ou 16 surtout lorsque celles-ci sont formées principalement à base d'argent.

Bien entendu, la présente invention ne se limite pas à l'exemple illustré mais est susceptible de diverses variantes et modifications qui apparaîtront à l'homme de l'art. En particulier, l'application de l'élément céramique incrusté 10 selon l'invention ne saurait se limiter à une pièce d'horlogerie 1. Ainsi, l'élément céramique incrusté 10 pourrait, à titre d'exemple, être appliqué à un article de bijouterie ou de joaillerie ou encore aux arts de la table.

De plus, la réalisation des évidements 12 lors de l'étape 23 pourrait également être réalisée sur le corps vert 17, c'est-à-dire avant la fin du processus de frittage. Cependant, il faudrait alors tenir compte du retrait du corps 11 final par rapport au corps vert 17. De même, les évidements 12 ne sont pas nécessairement borgnes comme dans l'exemple illustré aux figures 5 à 8 mais peuvent être tous ou seulement en partie traversant. Selon un raisonnement voisin, au moins un évidement peut comporter une épaisseur P non plan et supérieure à 100 µm.

Enfin, il est également à noter que l'étape 24 n'est pas limitée à une autocatalyse chimique mais peut être alternativement réalisée, par exemple, par un dépôt chimique en phase vapeur ou un bombardement ionique.

## Revendications

1. Procédé de fabrication (21) d'un élément céramique incrusté (10) comportant les étapes suivantes :
a) former (22) un corps (11) en céramique ;
b) graver (23) par laser au moins un évidement (12) comportant une profondeur (P) minimale de 100 µm dans une face (F) du corps (11) en céramique, chaque au moins un évidement formant l'empreinte d'un décor (13) ;
c) déposer (24, 25) une première couche (14) de 50 nm sur l'ensemble de la face (F) comportant ledit au moins un évidement ;
d) déposer (26) une deuxième couche (15) électriquement conductrice de 50 nm sur l'ensemble de la face (F) comportant ledit au moins un évidement en recouvrement de la première couche (14) ;
e) déposer (27) galvaniquement un matériau métallique (16) à partir de la deuxième couche conductrice (15) afin de remplir complètement ledit au moins un évidement ;
f) retirer (28) tous les dépôts (14, 15, 16) de la surface du corps (11) en céramique afin de n'en laisser que dans le creux dudit au moins un évidement.

2. Procédé (21) selon la revendication précédente, **caractérisé en ce que** l'étape a) est réalisée par frittage.

3. Procédé (21) selon la revendication 1 ou 2, **caractérisé en ce que** le corps (11) en céramique est formé à base de zircone.

4. Procédé (21) selon l'une des revendications 1 à 3, **caractérisé en ce que** chaque au moins un évidement (12) comporte une surface interne sans arête afin de faciliter la mise en oeuvre de l'étape e).

5. Procédé (21) selon l'une des revendications 1 à 4, **caractérisé en ce que** l'étape c) est réalisée par autocatalyse chimique.

6. Procédé (21) selon la revendication précédente, **caractérisé en ce que** la première couche (14) comporte du nickel-phosphore.

7. Procédé (21) selon l'une des revendications 1 à 4, **caractérisé en ce que** l'étape c) est réalisée par dépôt physique en phase vapeur.

8. Procédé (21) selon la revendication précédente, **caractérisé en ce que** la première couche (14) est du type Cr, Cr₂N, TiN, TiW, Ni, Cu, Ti ou Zr.

9. Procédé (21) selon l'une des revendications 1 à 8, **caractérisé en ce que** l'étape d) est réalisée par dépôt physique en phase vapeur.

10. Procédé (21) selon l'une des revendications 1 à 9, **caractérisé en ce que** la deuxième couche électriquement conductrice (15) comporte de l'or et/ou du cuivre et/ou de l'argent et/ou de l'indium et/ou du platine et/ou du palladium et/ou du nickel afin d'optimiser son adhérence, sa bonne conductivité électrique et une teinte proche du dépôt galvanique (16).

11. Procédé (21) selon l'une des revendications 1 à 10, **caractérisé en ce que** le matériau métallique (16) déposé lors de l'étape e) comporte de l'or et/ou du cuivre et/ou de l'argent et/ou de l'indium et/ou du platine et/ou du palladium et/ou du nickel.

12. Procédé (21) selon l'une des revendications 1 à 11, **caractérisé en ce qu'**il comporte une étape finale g) destinée à déposer (29) une couche (18) transparente afin de protéger les décors (13) du vieillissement.

13. Procédé (21) selon la revendication précédente, **caractérisé en ce que** la couche de protection (18) comporte du nitrure de silicium.

## Patentansprüche

1. Verfahren (21) für die Herstellung eines mit Intarsien verzierten Keramikelements (10), das die folgenden Schritte umfasst:
a) Bilden (22) eines Körpers (11) aus Keramik;
b) Schneiden (23) mittels Laser wenigstens einer Aussparung (12), die eine minimale Tiefe (P) von 100 µm besitzt, in eine Fläche (F) des Körpers (11) aus Keramik, wobei jede der wenigstens einen Aussparung den Eindruck einer Verzierung (13) bildet;
c) Abscheiden (24, 25) einer ersten Schicht (14) von 50 nm auf der gesamten Fläche (F), die die wenigstens eine Aussparung aufweist;
d) Abscheiden (26) einer zweiten elektrisch leitenden Schicht (15) von 50 nm auf der gesamten Fläche (F), die die wenigstens eine Aussparung aufweist, wodurch die erste Schicht (14) abgedeckt wird;
e) galvanisches Abscheiden (27) eines Metallmaterials (16) auf der zweiten leitenden Schicht (15), um die wenigstens eine Aussparung vollständig zu füllen;
f) Entfernen (28) sämtlicher Abscheidungen (14, 15, 16) von der Oberfläche des Körpers (11) aus Keramik, um sie nur in dem Hohlraum der wenigstens einen Aussparung zurückzulassen.

2. Verfahren (21) nach dem vorhergehenden Anspruch, **dadurch gekennzeichnet, dass** der Schritt a) durch Sintern ausgeführt wird.

3. Verfahren (21) nach Anspruch 1 oder 2, **dadurch gekennzeichnet, dass** der Körper (11) aus Keramik auf Zirkonbasis gebildet ist.

4. Verfahren (21) nach einem der Ansprüche 1 bis 3, **dadurch gekennzeichnet, dass** jede der wenigstens einen Aussparung (12) eine innere Oberfläche ohne Kanten aufweist, um die Ausführung des Schrittes e) zu erleichtern.

5. Verfahren (21) nach einem der Ansprüche 1 bis 4, **dadurch gekennzeichnet, dass** der Schritt c) durch chemische Autokatalyse ausgeführt wird.

6. Verfahren (21) nach dem vorhergehenden Anspruch, **dadurch gekennzeichnet, dass** die erste Schicht (14) Nickel-Phosphor enthält.

7. Verfahren (21) nach einem der Ansprüche 1 bis 4, **dadurch gekennzeichnet, dass** der Schritt c) durch physikalische Abscheidung aus der Dampfphase ausgeführt wird.

8. Verfahren (21) nach dem vorhergehenden Anspruch, **dadurch gekennzeichnet, dass** die erste Schicht (14) vom Typ Cr, Cr₂N, TiN, TiW, Ni, Cu, Ti oder Zr ist.

9. Verfahren (21) nach einem der Ansprüche 1 bis 8, **dadurch gekennzeichnet, dass** der Schritt d) durch physikalische Abscheidung aus der Dampfphase ausgeführt wird.

10. Verfahren (21) nach einem der Ansprüche 1 bis 9, **dadurch gekennzeichnet, dass** die zweite elektrisch leitende Schicht (15) Gold und/oder Kupfer und/oder Silber und/oder Indium und/oder Platin und/oder Palladium und/oder Nickel enthält, um ihre Haftung, ihre gute elektrische Leitfähigkeit und eine Färbung in der Nähe der galvanischen Ablagerung (16) zu optimieren.

11. Verfahren (21) nach einem der Ansprüche 1 bis 10, **dadurch gekennzeichnet, dass** das Metallmaterial (16), das im Schritt e) abgelagert wird, Gold und/oder Kupfer und/oder Silber und/oder Indium und/oder Platin und/oder Palladium und/oder Nickel enthält.

12. Verfahren (21) nach einem der Ansprüche 1 bis 11, **dadurch gekennzeichnet, dass** es einen letzten Schritt g) umfasst, der dazu bestimmt ist, eine lichtdurchlässige Schicht (18) abzulagern (29), um die Verzierungen (13) vor Alterung zu schützen.

13. Verfahren (21) nach dem vorhergehenden Anspruch, **dadurch gekennzeichnet, dass** die Schutzschicht (18) Siliciumnitrid enthält.

## Claims

1. Method (21) of manufacturing an inlaid ceramic element (10) including the following steps:
a) forming (22) a ceramic body (11);
b) etching (23) by laser at least one recess (12) having a minimal depth (P) of 100µm in one face (F) of the ceramic body (11), each at least one recess forming the pattern for a decoration (13);
c) depositing (24, 25) a first layer (14) of 50 nm over the entire face (F) including said at least one recess;
d) depositing (26) a second electrically conductive layer (15) of 50 nm over the entire face (F) including said at least one recess, so as to cover the first layer (14);
e) depositing (27) galvanically of a metallic material (16) from the second conductive layer (15) so as to completely fill said at least one recess;
f) removing (28) all the deposits (14, 15, 16) from the surface of the ceramic body (11), except from the hollow of said at least one recess.

2. Method (21) according to the preceding claim, **characterized in that** step a) is achieved by sintering.

3. Method (21) according to claim 1 or 2, **characterized in that** the ceramic body (11) is zirconia-based.

4. Method (21) according to any of claims 1 to 3, **characterized in that** each at least one recess (12) includes an inner surface with no edges so as to facilitate implementation of step e).

5. Method (21) according to any of claims 1 to 4, **characterized in that** step c) is achieved by electroless plating.

6. Method (21) according to the preceding claim, **characterized in that** the first layer (14) includes nickel-phosphorus.

7. Method (21) according to claims 1 to 4, **characterized in that** step c) is achieved by vapour phase deposition.

8. Method (21) according to claim 7, **characterized in that** the first layer (14) is a Cr, Cr₂N, TiN, TiW, Ni, NiP, Cu, Ti or Zr layer.

9. Method (21) according to any of claims 1 to 8, **characterized in that** step d) is achieved by vapour phase deposition.

10. Method (21) according to any of claims 1 to 9, **characterized in that** the second electrically conductive layer (15) includes gold and/or copper and/or silver and/or indium and/or platinum and/or palladium and/or nickel so as to optimise the adherence and good electrical conductivity thereof, and provide a colour close to the galvanic plating (16).

11. Method (21) according to any of claims 1 to 10, **characterized in that** the metallic material (16) deposited during step e) includes gold and/or copper and/or silver and/or indium and/or platinum and/or palladium and/or nickel.

12. Method (21) according to any of claims 1 to 11, **characterized in that** it includes a final step g) for depositing (29) a substantially transparent layer (18) so as to protect the decorations (13) from ageing.

13. Method (21) according to claim 12, **characterized in that** the protective layer (18) includes silicon nitride.
